# EUROPÄISCHE PATENTANMELDUNG

(11) **EP 1 271 165 A2**
(43) Veröffentlichungstag der Anmeldung: **02.01.2003**
(21) Anmeldenummer: 02450110.8
(22) Anmeldetag: 02.05.2002
(51) Int. Cl.: G01R 31/04

(54) **Prüfung von Kabelbäumen**

(30) Priorität: 27.06.2001 AT 10012001
(71) Anmelder: I & T Flachleiter Produktions-Ges.m.b.h., 7000 Eisenstadt (AT)
(72) Erfinder: Dragov, Nikola, Dipl.-Ing., 2344 Maria Enzersdorf (AT); Schindler, Uwe, 22941 Jersbek (DE)
(74) Vertreter: Patentanwälte BARGER, PISO & PARTNER

(57) **Zusammenfassung**

Die Erfindung betrifft eine Vorrichtung zur Überprüfung von Kabelbäumen bzw. Teilen von Kabelbäumen, die zumindest teilweise aus Flachleiterkabeln (8) bestehen, deren Enden mit Steckern (5) versehen sind.

Die Erfindung ist dadurch gekennzeichnet, dass korrespondierend zu den Steckern der zu prüfenden Flachleiterkabeln eines mit einem Träger oder Carrier (1) verbundenen, gegebenenfalls gefalteten Kabelbaums auf einem Prüftisch (2) Aufnahmen (6) vorgesehen sind, dass Bewegungsvorrichtungen vorgesehen sind, durch die eine Relativbewegung (RP) zwischen dem Carrier (1) und dem Prüftisch (2) von einer Ruheposition in eine Prüfposition und zurück ermöglicht wird und dass den Aufnahmen (6), die sich in der Prüfposition nicht in einer Kontaktposition befinden, in der sie mit den Steckern (5) kontaktierend verbunden sind, Endbewegungsvorrichtungen (7) zugeordnet sind, durch die sie von der Prüfposition in die Kontaktposition und zurück gebracht werden können.

## Beschreibung

Die Erfindung betrifft die Prüfung von Kabelbäumen und insbesondere die Prüfung von Kabelbäumen, die zumindest teilweise aus Flachleiterkabeln bestehen.
Die Herstellung von Kabelbäumen für die Kraftfahrzeugindustrie gehört zu den arbeitsaufwendigsten Tätigkeiten, die im Zuge der Herstellung eines Kraftfahrzeuges geleistet werden müssen. Es muß dabei eine passende Vielzahl von elektrischen Leitern passend miteinander verbunden werden, es müssen an den freien Enden der Leiter Stecker angebracht, d.h. elektrisch leitend mit den Leitern verbunden und mechanisch an den Kabeln fixiert werden, und es ist unbedingt notwendig, dass diese Kabelbäume zumindest nach ihrer Herstellung, besser jeweils nach einem oder mehreren Fertigungsschritten auf ihre Funktionstüchtigkeit geprüft werden. Dabei ist noch zu beachten, dass die Kabelbäume für ihren Transport zur Montagestelle, an der sie in ein Kraftfahrzeug eingebracht und entsprechend mit der Stromquelle bzw. den Stromverbrauchern verbunden werden, gerollt bzw. gefaltet werden, da sie im ausgestreckten Zustand, in dem sie ursprünglich hergestellt werden, eine Fläche beanspruchen, die einen Transport unmöglich macht.
Dieses Rollen bzw. Falten der Kabelbäume stellt nun eine mechanische Beanspruchung dar, die wiederum dazu führen kann, dass sich Verbindungsstellen, beispielsweise gelötete, geschweißte oder sonstige Verbindungsstellen, unter dieser mechanischen Beanspruchung lösen und so der Kabelbaum unbrauchbar wird. Es ist daher besonders gewünscht, den Kabelbaum erst bzw. auch nach dem Falten auf seine Integrität zu prüfen.
Bisher war es nicht möglich, eine derartige Prüfung vorzunehmen, in den Prüfvorrichtungen des Standes der Technik wird der Kabelbaum im fertiggestellten, aber noch ungefalteten Zustand auf einen Prüftisch gelegt, die einzelnen Stecker werden händisch in entsprechende Aufnahmen eingebracht, nach dem Einführen aller Stecker erfolgt die Prüfung, die Stecker werden von den Aufnahmen frei gegeben und je nach dem Resultat der Prüfung erfolgt das Rollen bzw. das Falten und der Transport des als in Ordnung befundenen oder eine Reparatur oder Vernichtung des als defekt befundenen Kabelbaumes.
Im internen Stand der Technik der Anmelderin ist auch eine verbesserte Anlage bekannt, die es ermöglicht, platzsparende Aufnahmen am Prüftisch anzubringen und so auf einem Prüftisch genügend Aufnahmen für mehrere unterschiedliche Kabelbäume vorzusehen, wobei auch die Fixierung der Stecker in den Aufnahmen verbessert ist. Es weist allerdings auch diese verbesserte Variante nicht die Möglichkeit auf, einen bereits gerollten bzw. gefalteten Kabelbaum, insbesondere wenn der Kabelbaum zumindest teilweise aus Flachleiterkabelsätzen besteht, zu prüfen.
Es muß hier auf die Besonderheiten von Kabelbäumen eingegangen werden, die zumindest teilweise aus Flachleiterkabeln bestehen: Flachleiterkabel weisen im Vergleich zu üblichen Rundkabeln eine anisotrope Steifigkeit auf. Der Grund dafür ist die flächige Anordnung der einzelnen Adern oder Litzen nebeneinander, woher derartige Kabelsätze ja auch ihren Namen haben. Es ist aufgrund dieses Aufbaues ohne großen mechanischen Aufwand und ohne Beschädigungsgefahr für die Flachleiter möglich, sie aus der Ebene heraus zu biegen und zu falten, doch es ist praktisch nicht möglich, sie in der Ebene zu falten, ohne sie zu beschädigen und ohne großen Kraftaufwand zu treiben.
Diese auf den ersten Blick als Nachteil erscheinende Eigenschaft hat aber den großen Vorteil, dass die Anbringung von Steckern an den Flachleitern wesentlich einfacher, zuverlässiger als bei Rundleitern und vor allem automatisch erfolgen kann, während eine entsprechende Tätigkeit bei den üblichen, gegebenenfalls auch verdrillten Rundleitern ausschließlich händisch möglich ist. Dies ist auch der Grund dafür, dass derartige Flachleiter in der industriellen Fertigung und insbesondere im Automobilbau, zunehmend interessant werden.
Da derartige Flachleiter Leiterbahnen aufweisen, deren Erstreckung in der Höhe (normal zu der durch den Flachleiter definierten Ebene) oft nur Bruchteile von Millimetern beträgt und da die elektrische Kontaktierung derartiger Flachleiter untereinander in vielen Fällen durch partielles Abtragen der Isolierung (Folie oder Extrudat), anschließendes Verschweißen (Reibschweißen z.B. mittels Ultraschall, Wiederstandsschweißen, Laserschweißen oder auch andere Schweiß- und Verbindungstechnologien) und schließliches Aufbringen einer isolierenden Umhüllung geschaffen wird, ist es einsichtig, dass diese elektrischen Verbindungen gegenüber mechanischen Beanspruchungen empfindlich sind.
Dies wiederum erhöht die Notwendigkeit, Kabelbäume nicht nur während und nach ihrer Herstellung, sondern erst/auch nach erfolgter Faltung für den Transport zu prüfen, da durch das Falten, insbesondere derartige elektrischen Verbindungen, die nach der Herstellung zwar elektrisch leitend waren, bei der Beanspruchung durch das Falten aber mechanisch gebrochen sind, ebenfalls erkennen zu können.

Die Erfindung hat das Ziel und die Aufgabe, eine derartige Prüfvorrichtung bzw. ein derartiges Prüfverfahren zu schaffen, die bzw. das in der Lage ist, einen gefalteten, zumindest teilweise aus Flachleiterkabelsätzen bestehenden Kabelbaum zu prüfen.
Erfindungsgemäß werden diese Ziele dadurch erreicht, dass, korrespondierend mit den Steckern der zu prüfenden Flachleiterkabeln eines mit einem Träger verbundenen, gefalteten Kabelbaums auf einem Prüftisch, Aufnahmen vorgesehen sind, dass Bewegungsvorrichtungen vorgesehen sind, durch die eine Relativbewegung zwischen dem Träger und dem Prüftisch von einer Ruheposition in eine Prüfposition und zurück ermöglicht wird und dass den Aufnahmen, die sich in der Prüfposition nicht in einer Kontaktposition befinden, in der sie mit den Steckern kontaktierend verbunden sind, Endbewegungsvorrichtungen zugeordnet sind, durch die sie von der Prüfposition in die Kontaktposition und zurück gebracht werden können.
Dies bedeutet mit anderen Worten, dass die Aufnahmen des Prüftisches bei denen dessen Bewegung mit der Einschubrichtung der zu prüfenden Stecker übereinstimmt, direkt durch dessen Bewegung in die Prüfposition auch in die Kontaktposition gelangen und dass die anderen Aufnahmen dabei in eine Position, auch Prüfposition genannt, gelangen, in der sie sich in Einschubrichtung vor den zu prüfenden Steckern befinden, sodass sie durch die Aktivierung der Endbewegungsvorrichtungen in die Kontaktposition gelangen.
Da nun in den meisten Fällen der Prüftisch sich in seiner Ruheposition oberhalb oder unterhalb des Trägers befindet und die Relativbewegung in vertikaler Richtung erfolgt, können alle Stecker, die vertikal positioniert sind (und in die richtige Richtung orientiert sind) durch die Relativbewegung in die Prüfposition auch gleich kontaktiert werden. Die Aufnahmen für die anderen zu prüfenden Stecker müssen am Prüftisch so angeordnet sein, dass sie in dieser Prüfposition eine Lage genau "vor" ihren zugeordneten Steckern einnehmen,
Auf diese Weise ist es möglich, die mit den Flachleiterkabeln verbundenen Stecker und so zumindest die durch Flachleiterkabeln gebildeten Teile eines Kabelbaumes, somit dessen mechanisch heikle Teile, sowohl im Zuge der Herstellung, als auch erst nach erfolgter Faltung zu überprüfen und dadurch auch die Exemplare des Kabelbaums feststellen zu können, die erst durch die Beanspruchung beim Falten defekt geworden sind.
Ob bei Kabelbäumen, die teilweise aus Flachleiterkabeln und teilweise aus Rundkabeln bestehen, die Stecker, die mit den Rundkabeln verbunden sind, vor oder nach dem Falten, im Zuge des erfindungsgemäßen Verfahrens oder unabhängig davon geprüft werden, spielt wegen der mechanischen Stabilität der Rundkabel und ihrer Verbindungen, die ja praktisch zur Gänze aus Steckverbindungen und Abzweigverbindungen bestehen, da ein händisches Löten kaufmännisch unmöglich und ein automatisiertes Löten technisch unmöglich ist, für das erfindungsgemäße Verfahren keine Rolle.
Bevorzugt sollten bei Kabelbäumen, die nur aus Flachleiterkabeln bestehen, alle Stecker auch nach der Faltung geprüft werden, doch ist es denkbar, besonders die Flachleiter, die Leiterquerschnitte mit ausreichender Höhe und damit höhere mechanische Stabilität auch im Bereich von Lötstellen aufweisen oder Flachleiterkabel, die keine Lötstellen aufweisen, schon vor dem Falten zu prüfen, wenn dies auch nur in Ausnahmefällen sinnvoll scheint.
Der genannte Träger oder Carrier muß erfindungsgemäß eine Faltung zumindest eines Teiles des Kabelbaums erlauben bzw. bewirken. Üblicherweise befindet sich während der Fertigung des Kabelbaumes dessen Träger unter ihm, um eine leichtere Montage zu ermöglichen. Beim Falten des fertigen Kabelbaumes wird üblicherweise so vorgegangen, dass der Carrier um den Kabelbaum herum gefaltet wird, was es notwendig macht, den Carrier so auszugestalten, dass er im Bereich der Falte einen vorgegebenen Mindestradius für die Flachbandkabel garantiert, damit es in diesem Bereich nicht zum Knicken oder gar zum Stauchen der Flachleiterkabel kommt. Analog muß der Carrier, wenn der Kabelbaum so gefaltet wird, dass er um den Carrier gefaltet wird, im Bereich der Faltung sich entsprechend verkürzen oder zurückziehen können, was während des Faltens geschehen muß, um hier den Kabelbaum nicht zu überdehnen und ebenfalls zum Knicken oder gar zum Reißen zu führen.
In einer Ausgestaltung der Erfindung werden die Stecker der Flachleiter während oder unmittelbar nach ihrer Anbringung an den entsprechenden Enden der zugehörenden Flachleiter am Träger in Halterungen fixiert, die auch die genaue Übereinstimmung der Position der Stecker mit den Lagen der Aufnahmen der Prüfvorrichtung sicherstellen. Dies ermöglicht es auch, wenn es gewünscht oder notwendig ist, die Stecker eventuell im Kabelbaum vorhandener Rundkabel in entsprechenden Halterungen zu fixieren und erlaubt so eine gemeinsame und somit Zeit und Kosten sparende Prüfung beider Teile des Kabelbaumes.
Durch die erfindungsgemäße Ausgestaltung des Trägers wird auch der Transport des Kabelbaumes im Zuge seiner Herstellung von Station zu Station erleichtert, da die bereits verlegten und aufgebauten Teile des Kabelbaumes durch ihre Stecker mit hoher Präzision an der ihnen zugedachten Lage befestigt sind und es werden Beschädigungen vermieden, da die Fixierung an den mechanisch stabilsten Teilen, nämlich den Steckern selbst, erfolgt.
Die Erfindung wird in der Zeichnung schematisch dargestellt, dabei zeigt
die Fig. 1 einen Ausschnitt eines Carriers und eines Prüftisches im Bereich eines Steckers in der Grundposition und
die Fig. 2 den Ausschnitt der Fig. 1 in Kontaktposition.

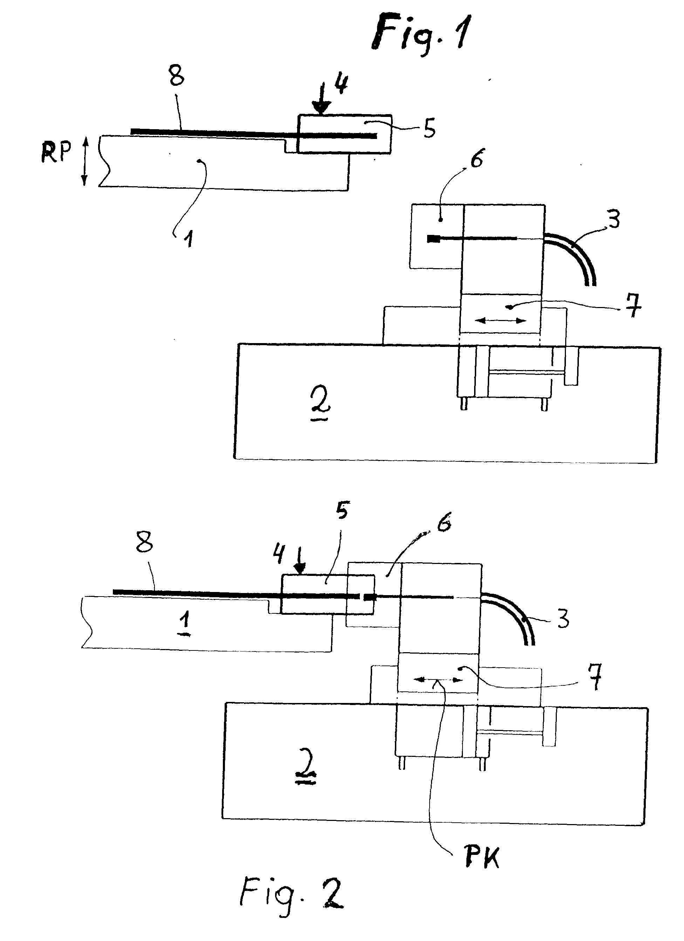

Aus dem Zusammenhalt der beiden Figuren ersieht man die durch Doppelpfeile RP angedeutete Relativbewegung zwischen Carrier 1 und Prüftisch 2 von der Grund- oder Ruheposition, in der die Montage des Kabelbaumes und das Falten erfolgt (Fig. 1) in die Prüfposition und durch Doppelpfeile PK angedeutet, die Endbewegung der Aufnahme von der Prüfposition in die Kontaktposition (Fig. 2), in der elektrischer Kontakt zwischen den elektrischen Leitern 3 der Aufnahme 6 und den elektrischen Leitern des Steckers 5 des Flachleiters 8 besteht.
Es ist aus der Zeichnung klar ersichtlich, dass die Aufnahmen 6 (beispielsweise für nach unten gerichtete Stecker), die in der Prüfposition auch schon die Kontaktposition erreicht haben, keine Endbewegung und daher keine entsprechende Endbewegungsvorrichtung 7 notwendig ist.
Es ist auch klar ersichtlich, dass der Winkel zwischen den beiden Bewegungen ein anderer als ein normaler Winkel sein kann und dass verschiedene Aufnahmen in verschiedenem Winkel und über verschiedene Weglängen ihre Endbewegung vollführen können. Wichtig ist nur, dass in der Prüfposition alle an der Prüfung beteiligten Aufnahmen fluchtend vor den Steckern positioniert sind, sodass sie im wesentlichen geradlinig in die Stecker geschoben werden können, und dass in der Ruheposition die Manipulation am und mit dem Carrier nicht behindert wird. Unter "im wesentlichen geradlinig" kann in Einzelfällen auch eine Drehbewegung mit relativ großem Radius fallen, wenn eine solche Drehbewegung für eine Aufnahme leichter zu bewerkstelligen ist als eine translatorische Bewegung.
Die Bewegung RP zwischen Carrier 1 und Prüftisch 2 erfolgt mittels nicht dargestellter Bewegungsvorrichtungen, die Bewegung PK zwischen der Prüfposition und der Kontaktposition einzelner Aufnahmen 6 mittels Endbewegungsvorrichtungen 7. Beide Arten von Bewegungsvorrichtungen weisen sowohl einen entsprechenden Antrieb als auch passende Führungen auf. Insbesondere im Endbereich jeder der beiden Bewegungen zueinander können trichterförmige Fang- bzw. Führungsvorrichtungen und entsprechende Gegenführungen für die notwendige Genauigkeit der Relativposition sorgen, ohne dass der ganze Bewegungsweg mit dieser nur mit hohen Kosten erreichbaren Genauigkeit gebaut und justiert sein müßte.
Es ist aus der Zeichnung unmittelbar zu entnehmen, dass es möglich ist, einzelne Aufnahmen bzw. Gruppen von Aufnahmen unabhängig voneinander gegenüber dem (gefalteten) Kabelbaum von der Ruheposition in die Prüfposition zu bewegen oder auch durch eine einzige Relativbewegung zwischen dem Kabelbaum und allen Aufnahmen von der einen in die andere Position zu kommen. Dies hängt von dem Aufbau und der Komplexität des Kabelbaumes und den zur Verfügung stehenden Vorrichtungen ab.
Die Antriebsaggregate für die einzelnen Bewegungen arbeiten auf pneumatischer oder elektrischer Basis, theoretisch wäre auch ein hydraulischer Antrieb möglich, doch wird dies wegen der Verschmutzungsgefahr nur in seltenen Ausnahmefällen in Frage kommen. Die einzelnen Vorrichtungen und Führungen können vom Fachmann in Kenntnis der Erfindung und unter Berücksichtigung der jeweiligen Vorgaben an den Kabelbaum leicht entworfen und gebaut werden und bedürfen hier keiner weiteren Erläuterung.
Die Stecker 5 sind zumindest während der Endbewegung PK bevorzugt am Carrier 1 fixiert, um ein problemloses Einbringen in die Aufnahmen 6 zu ermöglichen. Diese Fixierung kann auf verschiedene Weise (gefederte Bügel, Gegenhalter, etc.) erfolgen, ist in der Zeichnung mittels eines Pfeiles 4 rein schematisch angedeutet und muß nach erfolgter Prüfung möglichst einfach zu Lösen sein. Bevorzugt werden in vielen Fällen Ausbildungen der Fixierung, die mit der zugeordneten Aufnahme so zusammenwirken, dass beim Trennen des Kontaktes auch die Fixierung des Steckers gelöst wird. Wenn allerdings nach dem Trennen des Kontaktes weitere Arbeitsschritte mit dem Kabelbaum unternommen werden, so wird bevorzugt, dass die Stecker weiter fixiert bleiben.

## Patentansprüche

1. Vorrichtung zur Überprüfung von Kabelbäumen bzw. Teilen von Kabelbäumen, die zumindest teilweise aus Flachleiterkabeln (8) bestehen, deren Enden mit Steckern (5) versehen sind, **dadurch gekennzeichnet, dass** korrespondierend zu den Steckern der zu prüfenden Flachleiterkabeln eines mit einem Träger oder Carrier (1) verbundenen, gegebenenfalls gefalteten Kabelbaums auf einem Prüftisch (2) Aufnahmen (6) vorgesehen sind, dass Bewegungsvorrichtungen vorgesehen sind, durch die eine Relativbewegung (RP) zwischen dem Carrier (1) und dem Prüftisch (2) von einer Ruheposition in eine Prüfposition und zurück ermöglicht wird und dass den Aufnahmen (6), die sich in der Prüfposition nicht in einer Kontaktposition befinden, in der sie mit den Steckern (5) kontaktierend verbunden sind, Endbewegungsvorrichtungen (7) zugeordnet sind, durch die sie von der Prüfposition in die Kontaktposition und zurück (PK) gebracht werden können.

2. Vorrichtung nach Anspruch 1, **dadurch gekennzeichnet, dass** die Bewegungsvorrichtungen und/oder die Endbewegungsvorrichtungen (7) Führungen aufweisen die im Bereich der Endbewegung der Bauteile zueinander eine höhere Genauigkeit aufweisen als in anderen Bereichen.

3. Vorrichtung nach Anspruch 1 oder 2, **dadurch gekennzeichnet, dass** die Bewegungsvorrichtungen und/oder die Endbewegungsvorrichtungen (7) pneumatisch betrieben werden.

4. Vorrichtung nach einem der voranstehenden Ansprüche, **dadurch gekennzeichnet, dass** der Carrier (1) zumindest für einen Stecker (5) eine Fixiervorrichtung (4) aufweist.
